# EUROPÄISCHE PATENTANMELDUNG

(11) **EP 1 231 627 A2**
(43) Veröffentlichungstag der Anmeldung: **14.08.2002**
(21) Anmeldenummer: 02000886.8
(22) Anmeldetag: 15.01.2002
(51) Int. Cl.: H01L 21/00, H01L 23/544

(54) **Markiervorrichtung und zugehöriges Markierverfahren**

(30) Priorität: 15.01.2001 DE 20100659 U
(71) Anmelder: Innolas GmbH, 82152 Krailling (DE)
(72) Erfinder: Behr, Andreas, 86899 Landsberg (DE)
(74) Vertreter: Seitz, Ralf, Dipl.-Ing.

(57) **Zusammenfassung**

Die vorliegende Erfindung betrifft eine Markiervorrichtung und ein zugehöriges Verfahren zum Markieren oder Mikropunktmarkieren eines Gegenstands, eines Wafers oder einer Schicht, insbesondere aus Siliciumcarbid, Indiumphosphid, Galliumarsenid, Germanium, Silizium, Galliumarsenidphosphid, Lithiumniobat, Lithiumtantalat, Quarz oder Saphir, mit einer Lasereinrichtung (1), die einen Laserstrahl (2) erzeugt, und einer Fokussiereinrichtung (6), die den von der Lasereinrichtung (1) erzeugten Laserstrahl auf eine zu markierende Oberfläche des Gegenstands, des Wafers oder der Schicht fokussiert, wobei die Lasereinrichtung (1) einen Laserstrahl mit einer Wellenlänge im Bereich des Ultravioletten erzeugt.

## Beschreibung

Die vorliegende Erfindung betrifft eine Markiervorrichtung und ein zugehöriges Markierverfahren zum Markieren oder zum Mikropunktmarkieren eines Gegenstands, z.B. eines Wafers aus Siliziumcarbid oder Saphir, mittels Laserstrahlung gemäß dem Oberbegriff von Anspruch 1 bzw. dem Oberbegriff von Anspruch 6.

Eine bekannte Markiervorrichtung und ein zugehöriges Verfahren zur Kennzeichnung von Halbleiteroberflächen durch Laserstrahlung sind in der EP 0 134 469 B1 beschrieben. Die bekannte Vorrichtung verwendet einen Nd:YAG-Laser als Strahlungsquelle, deren Laserstrahl mit einer Wellenlänge von 1064 nm über eine Linse auf die Oberfläche eines polierten Siliziumwafers oder Germaniumwafers fokussiert wird, um einen Mikropunkt, also ein kreisförmiges Flächenmotiv, oder ein Mikropunktmuster zur Kennzeichnung des Wafers auszubilden. Die mit der bekannten Vorrichtung erzeugbaren kreisförmigen Flächenmotive sind auf einen Durchmesser von minimal 50 Mikrometer bei noch ausreichender Lesbarkeit der erzeugten Markierung bei Germanium und Silizium beschränkt.

Aufgabe der Erfindung ist es, eine Vorrichtung zum Markieren einer Materialoberfläche, z.B. eines Wafers aus Siliziumcarbid, anzugeben, die slag-freie Mikromarkierungen auch unter 50 Mikrometer ermöglicht.

Diese Aufgabe wird durch die Vorrichtung nach Anspruch 1 bzw. das Verfahren nach Anspruch 6 gelöst. Demnach hat die erfindungsgemäße Vorrichtung zur Markierung oder Mikropunktmarkierung eines Gegenstands, eines Wafers oder einer Schicht, insbesondere aus Siliziumcarbid, Indiumphosphid, Galliumarsenid, Germanium, Silizium, Galliumarsenidphosphid, Lithiumniobat, Lithiumtantalat, Quarz oder Saphir, eine Lasereinrichtung, die einen Laserstrahl erzeugt, und eine Fokussiereinrichtung, die den von der Lasereinrichtung erzeugten Laserstrahl auf eine zu markierende Oberfläche des Gegenstands, des Wafers oder der Schicht fokussiert, wobei die Lasereinrichtung einen Laserstrahl mit einer Wellenlänge im Bereich des Ultravioletten erzeugt.

Durch die Verwendung der Vorrichtung der Erfindung können Mikropunktmarkierungen mit sehr kleinen Abmessungen bis herunter zu etwa einem Mikrometer mit praktisch vernachlässigbarer Slagbildung erzeugt werden, die somit einen scharfen Umriss haben und folglich wegen des hohen Kontrasts auch gut lesbar sind. Hinzu kommt eine geringere oder vernachlässigbare Verunreinigung des Wafers aufgrund der fehlenden Slagbildung.

Unter "Slag" wird hier ein Rand aus Schmelzperlen und breiten, unregelmäßigen Materialverwerfungen verstanden, der die Markierung, zum Beispiel eine kreisflächige Vertiefung, umsäumt und die Lesbarkeit der Markierung verschlechtert. Unter "Slag" wird hier auch eine Materialerhebung oder ein Hügel innerhalb der flächigen Mikromarkierung verstanden, der die Lesbarkeit des erzeugten Markierungsmusters verschlechtert und erschwert.

Unter "ultravioletter Strahlung" ist im Zusammenhang mit der Erfindung eine elektromagnetische Strahlung in einem Bereich zwischen weicher Röntgenstrahlung und dem sichtbaren Licht gemeint, also in einem Wellenlängenbereich von etwa 10 nm bis etwa 390 nm.

Bei dem Markierverfahren der Erfindung zum Markieren oder Mikropunktmarkieren eines Gegenstands, eines Wafers oder einer Schicht, insbesondere aus Siliziumcarbid, Indiumphosphid, Galliumarsenid, Germanium, Silizium, Galliumarsenidphosphid, Lithiumniobat, Lithiumtantalat, Quarz oder Saphir, wird der Laserstrahl mit einer Wellenlänge im Bereich des Ultravioletten von der Lasereinrichtung erzeugt und der erzeugte Laserstrahl wird mittels einer Fokussiereinrichtung auf eine zu markierende Oberfläche des Gegenstands fokussiert.

Es wird bevorzugt, dass ein gasförmiges Lasermedium der Lasereinrichtung Kryptonfluorid (KrF) aufweist und eine Laserstrahlung mit einer Wellenlänge von etwa 248 nm erzeugt wird, womit insbesondere eine slag-freie Markierung von Siliziumcarbid ermöglicht wird.

Das gasförmige Lasermedium der Lasereinrichtung besteht bevorzugt aus Argonfluorid (ArF) und es wird eine Laserstrahlung mit einer Wellenlänge von etwa 193 nm erzeugt, womit insbesondere Saphir fast slag-frei markiert werden kann.

Es kann auch ein Festkörperlasermedium bzw. ein Kristalllaser, z.B. Nd:YAG, insbesondere mit einer Strahlungswellenlänge von 266 nm (vervierfacht) oder 355 nm (verdreifacht), in der Lasereinrichtung verwendet werden, um die vorstehend genannten Materialien, insbesondere Siliziumcarbid, möglichst slag-frei zu markieren.

Bevorzugt wird die gleiche Stelle bzw. der gleiche Ort des zu markierenden Gegenstands mehrmals mit dem Laserstrahl beschossen, um an der Stelle eine Markierung, z.B. eine kreisflächige oder rechteckige Markierung, erzeugen zu können, was insbesondere bei der Markierung von Saphir zu slag-freien oder doch sehr slag-armen und damit scharfen Markierungen und Mikromarkierungen mit guter Lesbarkeit führt.

Der Laserstrahl kann aus einer zeitlichen Abfolge von einzelnen Laserstrahlungsimpulsen bestehen, wobei eine Gruppe aus mehreren, zeitlich hintereinanderfolgenden, einzelnen Laserstrahlungsimpulsen auf die gleiche Stelle der Oberfläche des zu markierenden Gegenstands geschossen werden kann, um an dieser Stelle des Gegenstands eine lesbare Markierung oder Mikromarkierung zu erzeugen.

Es kann eine matte Seite eines Wafers aus Saphir markiert werden, wobei eine Gruppe aus einzelnen Laserimpulsen mindestens zwei, bevorzugt vier, Laserimpulse aufweist. Es hat sich überraschenderweise herausgestellt, dass sich die matte Seite eines Saphir-Wafers erfolgreich und gut lesbar mit einer Laserschusszahl von mindestens zwei, bevorzugt vier, hintereinanderfolgenden Laserimpulsen eines ArF-Lasers markieren lässt.

Eine glänzend polierte Seite eines Wafers aus Saphir kann dagegen erst mit ausreichend guter Lesbarkeit markiert werden, wenn pro Stelle oder Ort auf der Saphiroberfläche eines Wafers hintereinanderfolgend mindestens fünf, bevorzugt mindestens fünfzehn, Laserimpulse eins ArF-Lasers auftreffen.

Bevorzugt wird eine Lasereinrichtung, die einen Laserstrahl mit einem rechtwinkligen Strahlenquerschnitt quer zur Strahlungsrichtung gesehen erzeugt, wodurch ebenso rechtwinklige Mikromarkierungen erzeugt werden können. Ein Zeichen, z.B. ein "A", das sich allgemein aus einer Vielzahl von Mikromarkierungen zusammensetzt, hat vorteilhaft bei rechteckigen Mikromarkierungen einen schärferen, geraden Rand im Vergleich zu kreisförmigen Markierungen, die einen eher ausgefransten, welligen Rand des Zeichens erzeugen. Der resultierende, schärfere Rand bei Zeichen aus Mikromarkierungen mit rechteckigem Umriss führt somit zu einer verbesserten Erkennbarkeit und Lesbarkeit des Zeichens aus rechteckigen Markierungen im Vergleich zu den Zeichen aus kreisförmigen Markierungen.

Weitere vorteilhafte Weiterbildungen sind den Unteransprüchen zu entnehmen.

Vorteilhafte Weiterbildungen, weitere Vorteile und Anwendungsmöglichkeiten der Erfindung sind der nachfolgenden Beschreibung bevorzugter Ausführungsformen der Erfindung in Verbindung mit den beiliegenden Zeichnungen zu entnehmen. Es zeigen:
- Fig. 1: eine Blockansicht, die schematisch den Aufbau einer ersten Ausführungsform der Vorrichtung der Erfindung mit einem KrF Excimer-Laser zeigt, der eine Laserstrahlung mit einer Wellenlänge von 248 nm erzeugt;
- Fig. 2: eine kreisflächige Mikropunktmarkierung, die von der Vorrichtung nach Fig. 1 auf einem Siliziumcarbid-Wafer erzeugt wurde, in vergrößerter Ansicht;
- Fig. 3 und Fig. 4: etwa rechteckige Mikropunktmarkierungen, die von der Vorrichtung nach Fig. 1 auf einem Siliziumcarbid-Wafer erzeugt wurden, in vergrößerter Ansicht;
- Fig. 5: kreisflächige Mikropunktmarkierungen, die von einer weiteren Ausführungsform der erfindungsgemäßen Vorrichtung, die im Unterschied zur Ausführungsform der Fig. 1 jedoch mit einem YAG-Laser bei 355 nm arbeitet, auf einem Siliziumcarbid-Wafer erzeugt wurden, in vergößerter Ansicht;
- Fig. 6: einen typischen Siliziumcarbid-Wafer mit Mikromarkierungen;
- Fig. 7: einen vergrößerten Ausschnitt aus einer Markierungsspur aus mehreren hintereinander gesetzten rechteckigen Mikropunktmarkierungen auf dem Wafer der Fig. 6, die mit einer noch weiteren Ausführungsform der erfindungsgemäßen Vorrichtung, die im Unterschied zur Ausführungsform der Fig. 1 jedoch mit einem Argonfluorid (ArF)-Laser bei 193 nm arbeitet, auf einem Siliziumcarbid-Wafer erzeugt wurde; und
- Fig. 8: eine im wesentlichen elliptische Markierung des Wafers der Fig. 6, die mit dem ArF-Laser erzeugt wurde, in vergrößerter Ansicht.

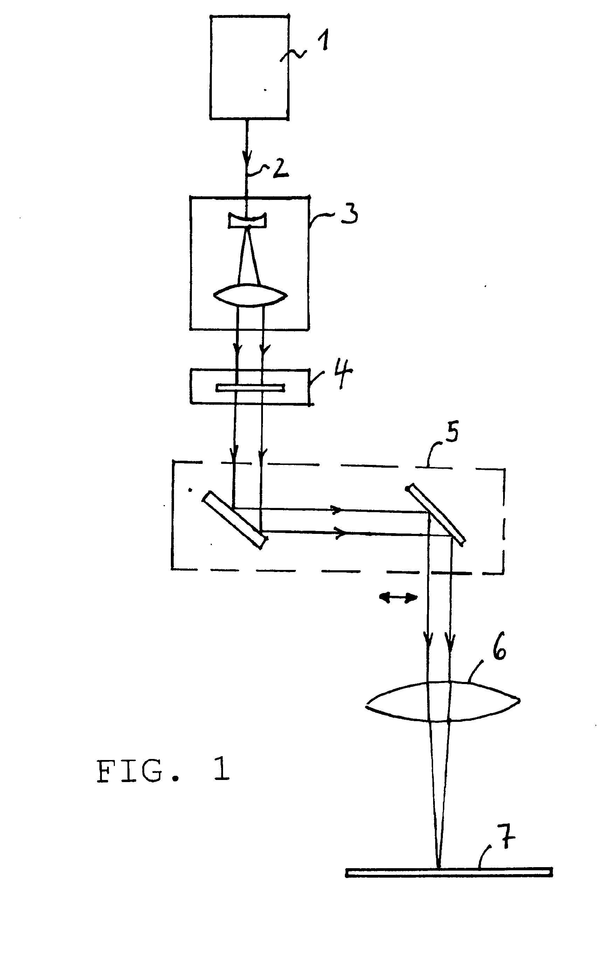

In der Fig. 1 ist schematisch der Aufbau einer ersten Ausführungsform der Vorrichtung der Erfindung mit einer Lasereinrichtung 1 gezeigt, die als Strahlungsquelle z.B. einen KrF Excimer-Laser 1 verwendet, der eine Laserstrahlung mit einer Wellenlänge von 248 nm im ultravioletten Bereich erzeugt. Die Vorrichtung hat weiterhin einen Aufweiter 3, z.B. einen Galileischen Aufweiter, eine Blende 4 oder Blendeneinrichtung mit z.B. einer Lochblende mit kreisrunder oder rechteckiger Blendenöffnung, eine Laserstrahlablenkeinheit 5 zur Bewegung bzw. zum Verfahren des Laserstrahls über dem zu beschreibenden Gegenstand, z.B. einem Wafer 7 aus Siliziumcarbid. Eine Galvanometerspiegeleinrichtung kann als Laserstrahlablenkeinheit 5 verwendet werden. Eine einstellbare Fokussiereinrichtung 6, z.B. eine F-Theta-Linse, wirft ausgangsseitig den Laserstrahl z.B. auf den Siliziumcarbid-Wafer 7. Zwischen der Blendeneinrichtung 4 und der Laserstrahlablenkeinheit 5 kann noch ein optischer Abschwächer zur Einstellung der Strahlenergie eingebaut sein. Eine nicht gezeigte, mikroprozessorgesteuerte und programmgestützte Steuereinheit bereitet die Markierungsdaten für die Lasereinrichtung 1 vor und steuert die Einrichtungen, die in Fig. 1 gezeigt sind. Der Laserstrahlgang ist mit dem Bezugszeichen 2 verdeutlicht.

Ein beispielhafter KrF-Laser zur Verwendung in der Ausführungsform von Fig. 1 arbeitet bei einer Wellenlänge von 248 nm und hat beispielsweise folgende Eigenschaften: Seine maximale Pulsenergie beträgt 18 mJ. Die maximale Repetitionsrate beträgt 1kHz und seine maximale Dauerleistung liegt bei 16 W. Seine Pulsdauer beträgt 15 ns in der Halbwertsbreite. Der erzeugte Laserstrahl ist rechteckig und hat typischerweise einen Strahlenquerschnitt von 3 mm horizontal und 6 mm vertikal, wieder in der Halbwertsbreite. Die Divergenz seines Laserstrahls beträgt 1 mrad horizontal und 1,5 mrad vertikal (voller Winkel bei halber Intensität). Die Puls-zu-Puls-Schwankung ist kleiner als 3 % (Standardabweichung).

In der Fig. 2 ist eine kreisflächige Mikromarkierung gezeigt, die mit der Vorrichtung nach Fig. 1 auf einem polierten Siliciumcarbid-Wafer unter Verwendung des KrF-Laser mit einer Energie von 7,5 mJ erzeugt wurde. Die erzeugte Mikromarkierung hat eine gleichmäßig scharfe Randwulst und eine gleichmäßige Innenfläche, wodurch ihre Lesbarkeit sichergestellt ist. Slag ist nicht zu erkennen. Der Durchmesser einer erzeugbaren Mikropunktmarkierung liegt in einem bevorzugten Bereich zwischen etwa 1 und etwa 15 Mikrometer. Die Tiefe der erzeugbaren, slag-freien Markierungen liegt in einem beispielhaften Bereich von 100 nm bis 7 Mikrometer. Slag-freie Markierungen konnten mit einer Laserenergie in einem Bereich zwischen etwa 6 mJ bis etwa 9mJ erreicht werden.

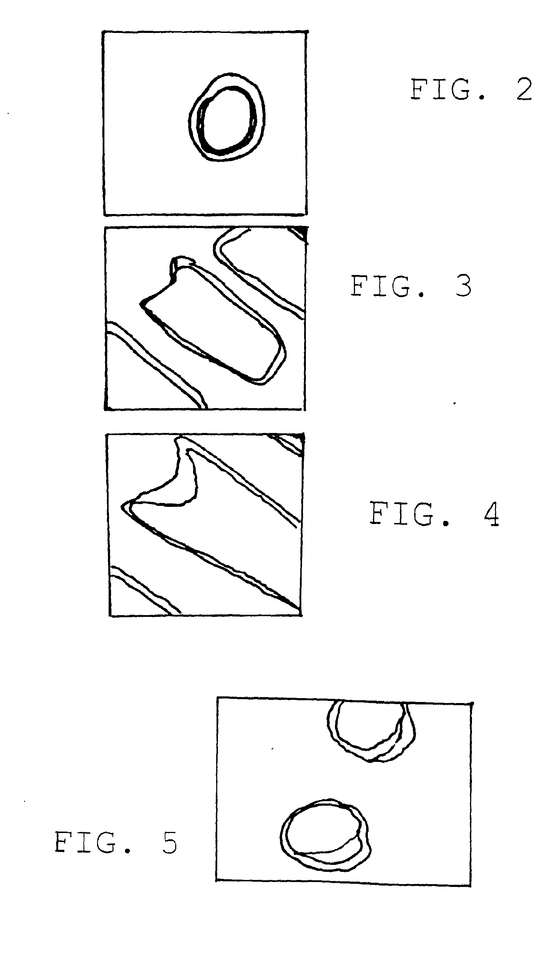

Die Fig. 3 und Fig. 4 zeigen etwa rechteckige Mikropunktmarkierungen, die mit einer zweiten Ausführungsform der Erfindung erzeugt wurden, die die Vorrichtung nach Fig. 1 mit dem besagten KrF-Gaslaser bei 248 nm auf einem Siliziumcarbid-Wafer jedoch mit geänderter, rechteckiger Blendenöffnung der Blendeneinheit 4 und geänderter Aufweitung des Aufweiters 3 aufweist. Auch diese rechteckigen Markierungen sind scharf begrenzt und zeigen nur vernachlässigbaren oder sehr geringen Slag.

Die Fig. 5 zeigt kreisflächige Mikropunktmarkierungen, die mit einer dritten Ausführungsform der Vorrichtung der Erfindung, die im Unterschied zur Ausführungsform der Fig. 1 jedoch mit einem YAG-Laser bei 355 nm arbeitet, auf einem Siliziumcarbid-Wafer erzeugt wurden. Auch mit dem YAG-Laser als Laserquelle konnte eine scharf umgrenzte, kreisflächige Mikropunktmarkierung auf poliertem SiC erzeugt werden.

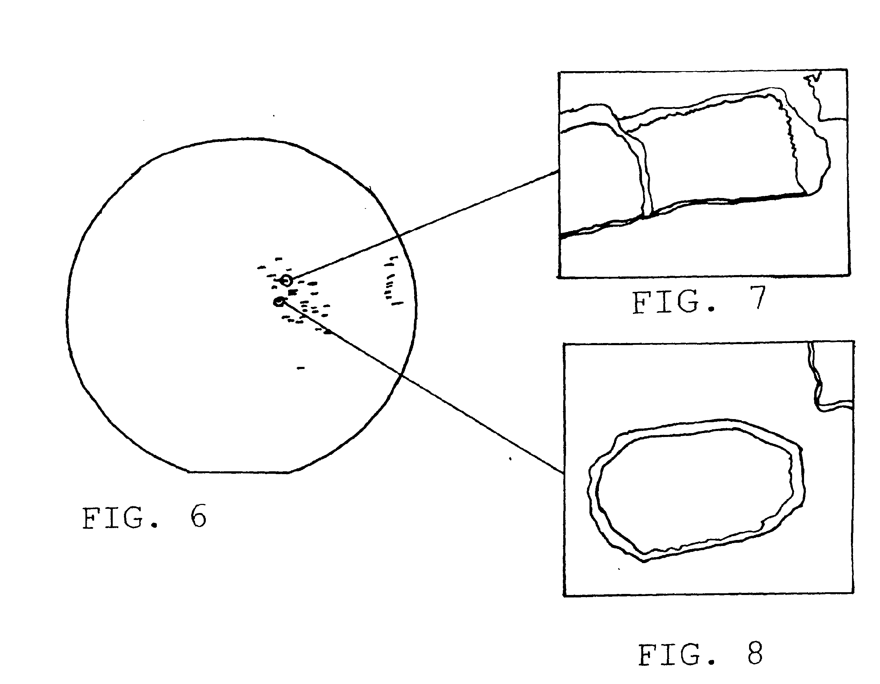

In der Fig. 6 ist ein typischer Siliziumcarbid-Wafer mit Mikromarkierungen gezeigt. Die Fig. 7 zeigt einen Ausschnitt aus einer Markierungsspur aus mehreren hintereinander gesetzten rechteckigen Mikropunktmarkierungen auf dem Wafer der Fig. 6, die mit einer vierten Ausführungsform der erfindungsgemäßen Vorrichtung der Erfindung erzeugt wurden, die im Unterschied zur Ausführungsform der Fig. 1 jedoch mit einem Argonfluorid (ArF)-Laser mit einer Wellenlänge von 193 nm arbeitet.

Auch die Fig. 8 zeigt eine im wesentlichen elliptische Markierung des Wafers der Fig. 6, die mit dem ArF-Laser mit einer Wellenlänge von 193 nm erzeugt wurde. Auch diese Markierungen zeigen scharfe, slag-freie Randbereiche ohne mittige Erhebung oder mittige Spitze innerhalb der Markierung.

Eine weitere, fünfte Ausführungsform der Erfindung umfasst eine Lasereinrichtung mit einem ArF-Laser, der einen Laserstrahl mit einer Wellenlänge von 193 nm erzeugt, eine Lochblende und eine Plankonvexlinse als Fokussiereinrichtung, wobei der von der Lasereinrichtung erzeugte Laserstrahl nach dem Durchgang durch die Lochblende von der Plankonvexlinse auf einen Wafer aus Saphir fokussiert wird, um auf dem Saphir-Wafer eine Markierung bzw. eine Mikromarkierung zu erzeugen. In Alternative kann in der fünften Ausführungsform auch die Vorrichtung der Fig. 1 mit dem ArF-Laser mit einer Wellenlänge von 193 nm zum Zwecke der Markierung des Saphirwafers verwendet werden.

Ein beispielhafter ArF-Laser hat eine maximale Energie von 8 mJ und eine Impulsdauer von 12 ns und erzeugt einen Laserstrahl mit einem rechteckigen Querschnitt von etwa 3 mm x 6 mm, der senkrecht zur Strahlungsrichtung gesehen ist. Die maximale Impulsfrequenz diese Lasers beträgt 1000 Hz. Die Lochblende kann beispielsweise eine Öffnung mit einem Durchmesser von 2,5 mm haben. Die Plankonvexlinse kann eine Brennweite von 50 mm haben. Die Intensität des Laserstrahls beträgt z.B. 18 J/cm².

Um eine lesbare Mikromarkierung auf z.B. dem Saphir-Wafer erzeugen zu können, wird die gleiche Stelle auf dem Saphir-Wafer mehrmals mit dem Laserstrahl in zeitlicher Abfolge beschossen, der durch die fünfte Ausführungsform der Vorrichtung der Erfindung erzeugt wird. Z.B. ist eine Gruppe aus mindestens vier Laserimpulsen mit jeweils 15 ns Impulsdauer erforderlich, um eine matte Seite eines Saphir-Wafers mit einer noch lesbaren, kreisflächigen Mikromarkierung zu versehen. Wird dagegen eine glänzende, polierte Oberfläche eines Saphir-Wafers markiert, wird der Saphir-Wafer mit einer Gruppe aus mindesten 15 Laserschüssen bzw. -impulsen bestrahlt, um eine Mikromarkierung an einer Stelle der Saphir-Oberfläche mit ausreichender Lesbarkeit und Qualität erzeugen zu können.

Die mit dem ArF-Laser bei 193 nm Wellenlänge jeweils durch Mehrmalbeschuss erzeugten Mikromarkierungen auf Saphir zeigen eine zu vernachlässigende Slagbildung und die gewünschte Lesbarkeit. Zudem können mit der ultravioletten Laserstrahlung von 193 nm Mikromarkierungen mit einem Durchmesser oder einer Abmessung bis minimal etwa 10 Mikrometer erzeugt werden. Mikrorisse des Saphirmaterials nach Durchführung des erfindungsgemäßen Markierverfahrens konnten nicht beobachtet werden.

Es hat sich weiterhin überraschenderweise herausgestellt, dass die Anzahl der erforderlichen, hintereinanderfolgenden Laserschüsse einer Gruppe von Laserschüssen zur Ausbildung einer einzigen lesbaren Mikromarkierung auf Saphir, insbesondere auf einem Saphir-Wafer, proportional bzw. linear mit der Zunahme eines Abstands oder Verfahrwegs zwischen zwei unmittelbar benachbarten, hintereinanderfolgenden Mikromarkierungen auf der Saphiroberfläche ansteigt. Unter Verwendung der Vorrichtung der fünften Ausführungsform bei einer Laserimpulsfrequenz von 10 Hz, einer Intensität von 18 J/cm² und einem verkleinernden Fokussierfaktor von 1/30 der Fokussiervorrichtung sind z.B. bei der Markierung einer glänzenden, polierten Saphir-Waferoberfläche etwa 50 Laserschüsse für Mikromarkierungen ausreichender Lesbarkeit pro Markierung erforderlich, wenn ein Abstand zwischen zwei unmittelbar hintereinanderfolgenden Mikromarkierungen 0,025 mm beträgt. 100 Laserschüsse sind hier bei einem Abstand bzw. Verfahrweg von 0,05 mm erforderlich und 200 Laserschüsse sind bei einem Abstand von 0,1 mm anzuwenden. Die Laserimpulsrate kann hier allgemein in einem Bereich zwischen etwa 10 und 1000 Hz liegen.

## Patentansprüche

1. Markiervorrichtung zum Markieren oder Mikropunktmarkieren eines Gegenstands, eines Wafers oder einer Schicht, insbesondere aus Siliziumcarbid, Indiumphosphid, Galliumarsenid, Germanium, Silizium, Galliumarsenidphosphid, Lithiumniobat, Lithiumtantalat, Quarz oder Saphir, mit einer Lasereinrichtung (1), die einen Laserstrahl (2) erzeugt, und einer Fokussiereinrichtung (6), die den von der Lasereinrichtung (1) erzeugten Laserstrahl auf eine zu markierende Oberfläche des Gegenstands, des Wafers oder der Schicht fokussiert, wobei die Lasereinrichtung (1) einen Laserstrahl mit einer Wellenlänge im Bereich des Ultravioletten erzeugt.

2. Markiervorrichtung nach Anspruch 1, **dadurch gekennzeichnet, dass** die Wellenlänge der Laserstrahlung in einem Bereich von 150 nm bis 360 nm liegt.

3. Markiervorrichtung nach Anspruch 1 oder Anspruch 2, **dadurch gekennzeichnet, dass** die Lasereinrichtung (1) einen Laser hat, der mit einem gasförmigen Lasermedium oder einem Festkörperlasermedium arbeitet.

4. Markiervorrichtung nach Anspruch 3, **dadurch gekennzeichnet, dass** das gasförmige Lasermedium Kryptonfluorid (KrF) aufweist.

5. Markiervorrichtung nach Anspruch 3, **dadurch gekennzeichnet, dass** das gasförmige Lasermedium Argonfluorid (ArF) aufweist.

6. Markierverfahren zum Markieren oder Mikropunktmarkieren eines Gegenstands, eines Wafers oder einer Schicht, insbesondere aus Siliziumcarbid, Indiumphosphid, Galliumarsenid, Germanium, Silizium, Galliumarsenidphosphid, Lithiumniobat, Lithiumtantalat, Quarz oder Saphir, wobei ein Laserstrahl durch eine Lasereinrichtung (1) erzeugt wird, der erzeugte Laserstrahl mittels einer Fokussiereinrichtung (6) auf eine zu markierende Oberfläche des Gegenstands fokussiert wird und der Laserstrahl mit einer Wellenlänge im Bereich des Ultravioletten von der Lasereinrichtung (1) erzeugt wird.

7. Markierverfahren nach Anspruch 6, **dadurch gekennzeichnet, dass** die Wellenlänge der Laserstrahlung in einem Bereich von 150 nm bis 360 nm liegt.

8. Markierverfahren nach Anspruch 7, **dadurch gekennzeichnet, dass** ein gasförmige Lasermedium der Lasereinrichtung Kryptonfluorid (KrF) aufweist und eine Laserstrahlung mit einer Wellenlänge von 248 nm erzeugt wird.

9. Markierverfahren nach Anspruch 7, **dadurch gekennzeichnet, dass** das gasförmiges Lasermedium der Lasereinrichtung Argonfluorid (ArF) aufweist und eine Laserstrahlung mit einer Wellenlänge von 193 nm erzeugt wird.

10. Markierverfahren nach einem der Ansprüche 6 bis 9, **dadurch gekennzeichnet, dass** die gleiche Stelle des zu markierenden Gegenstands mehrmals mit dem Laserstrahl bestrahlt wird, um an der Stelle eine Markierung zu erzeugen.

11. Markierverfahren nach Anspruch 10, **dadurch gekennzeichnet, dass** der Laserstrahl gepulst ist und mehrere, zeitlich hintereinanderfolgende Laserstrahlimpulse, die eine Gruppe aus Laserstrahlimpulsen festlegen, auf die gleiche Stelle des zu markierenden Gegenstands geschossen werden.

12. Markierverfahren nach Anspruch 11, **dadurch gekennzeichnet, dass** das gasförmiges Lasermedium der Lasereinrichtung Argonfluorid (ArF) aufweist, die eine Laserstrahlung mit einer Wellenlänge von 193 nm erzeugt, dass eine matte Seite eines Wafers aus Saphir markiert wird und dass die Gruppe mindestens zwei oder vier Laserstrahlimpulse aufweist.

13. Markierverfahren nach Anspruch 11, **dadurch gekennzeichnet, dass** das gasförmiges Lasermedium der Lasereinrichtung Argonfluorid (ArF) aufweist, die eine Laserstrahlung mit einer Wellenlänge von 193 nm erzeugt, dass eine glänzend polierte Seite eines Wafers aus Saphir markiert wird und dass die Gruppe mindestens fünf oder fünfzehn Laserstrahlimpulse aufweist.

14. Markierverfahren nach einem der Ansprüche 6 bis 13, **dadurch gekennzeichnet, dass** ein Laserstrahl mit einem rechteckigen Strahlenquerschnitt erzeugt wird.

15. Markierverfahren nach Anspruch 14, **dadurch gekennzeichnet, dass** der rechteckige Strahlenquerschnitt 3 mm in der Horizontalrichtung und 6 mm in der Vertikalrichtung beträgt, wobei diese Werte die Halbwertsbreite des Laserstrahls angeben.
